# EUROPEAN PATENT APPLICATION

(11) **EP 3 986 103 A1**
(43) Date of publication of application: **20.04.2022**
(21) Application number: 21197934.9
(22) Date of filing: 21.09.2021
(51) Int. Cl.: H05K 7/20

(54) **CHARGER**

(30) Priority: 14.10.2020 JP 2020173302; 14.10.2020 JP 2020173303
(71) Applicant: Hosiden Corporation, Yao-shi, Osaka 581-0071 (JP)
(72) Inventor: Yamanaka, Satoshi, Yao-shi, 5810071 (JP); Ito, Hiroaki, Yao-shi, 5810071 (JP)
(74) Representative: Lemcke, Brommer & Partner Patentanwälte Partnerschaft mbB

(57) **Abstract**

Provided is an inexpensive charger which is compact and which yet provides favorable heat dissipation performance. The charger (100) includes a charging circuit board (200) comprised of an input/output interface component (220, 230) and a charging circuit component (240, 250, 260) mounted on a substrate (210) having a first face (211) and a second face (212) which are in parallel and front/back relationship with each other and a housing (300) including a first housing body (310) to which the charging circuit board (200) is fixed and a second housing body (360) engageable with the first housing body (310) to form together an inner space (390) in which the charging circuit board (200) is to be accommodated. The second face (212) of the substrate (210) mounts thereon a heat generating component (240) included in the circuit component (240, 250, 260). A heat dissipation pattern (214) is formed at a part of the first face (211) overlapped with at least a part of the heat generating component (240) mounted on the second face (212) as seen in a direction perpendicular to the first face (211).

## Description

### Technical Field

This disclosure relates to a charger.

### Related Art

In recent years, with improvement of performance of the secondary batteries usable repeatedly with charging (to be referred to simply as a "battery" hereinafter), various devices or instruments exemplified by mobile electronic devices (to be referred to as "charged devices" hereinafter) are driven by a battery incorporated therein. When the battery is charged, a charger is used. With increasing compactization of the charged devices, compactization is demanded for the charger also.

A charger converts a commercial alternating current to a direct current of a rated volage for charging the battery and outputs such direct current. The charger incorporates a rectifier circuit for converting the commercial power alternating current to the direct current, a transformer for stepping down to the rated voltage for charging the battery, and so on and these circuit components are mounted on a circuit board. Among these, a diode of the rectifier circuit, an FET and a transistor as a switching device, the transformer for voltage conversion, etc. are classified as "heat generating components" which generate heat under their operational states. If dissipation of heat generated from such heat generating components under their operational states is insufficient, the heat generating components and other circuit components may be exposed to and damaged by adverse influence of temperature rise at the time of operation of the charger. For this reason, there is a need to suppress rising of temperature of the space inside the charger through efficient dissipation of heat generated from the heat generating components.

Recently, a quick charger capable of quick charging for reduction of charging time is also on sale. As a quick charger supplies a large current to a charged device, there occurs further increase in the heat generation amount. For this reason, the charger is equipped with a heat dissipation arrangement for dissipating generated heat to the outside.

In a charger, if the area of the circuit board is large or a large inner space is secured around the circuit board, heat generated from the heat generating components will be dissipated naturally, so the rise of temperature of the space inside the charger is mild. For this reason, in this case, a measure for positively dissipating heat generated from the heat generating components is not needed in particular in the charger. On the other hand, in case the charger is a compact type, the area of its circuit board is small, so there is high possibility of inability to secure sufficient capacity for the inner space around the circuit board. Therefore, in this case, there is a need for a certain measure for positively dissipating heat generated from the heat generating components. As some examples of such measure for dissipating heat generated from a heat generating component mounted on a circuit board, there are known ones as follows. In the technique disclosed in Japanese Unexamined Patent Application No. 2001-244675, a heat dissipation fin unit formed of e.g. aluminum is mounted erect on the lateral side of the circuit board, and a heat generating component on the circuit board and the heat dissipation fin unit are connected to each other via a heat conducting plate. Further, in the case of a technique disclosed in Japanese Unexamined Patent Application No. 2001-284748, there is provided a heat dissipating means having a plurality of fins on the back face of the circuit board opposite to the face thereof on which a heat generating component is mounted. As the heat dissipating means is disposed on the circuit board in the above-described manner, heat dissipation of heat generated from the heat generating component included in a charger can be readily dissipated from the heat dissipating member.

In a car-mounted electronic device disclosed in Japanese Unexamined Patent Application No. 2004-153034, a part of a housing (referred to as a "base" in the document) is formed of an aluminum diecast having good thermal conductivity. With this, heat generated from a heat generating component provided on a substrate (referred to as an "electronic substrate " in the document) can be dissipated from the base.

### SUMMARY

In the case of the arrangement of disposing a heat dissipating member on the lateral side or on the back face of a circuit board, like the techniques disclosed in Japanese Unexamined Patent Application No. 2001-244675 and Japanese Unexamined Patent Application No. 2001-284748, the heat dissipating member is needed, which leads to cost increase as well as reduction in readiness of assembly of components in a charger.

Further, in the case of the car-mounted electronic device disclosed in Japanese Unexamined Patent Application No.2004-153034, since a part of the housing is formed of an aluminum diecast having good thermal conductivity, even in the event of heat generation from the heat generating component, the heat can be dissipated from the housing formed of aluminum diecast, so heat dissipation performance is good. Further, in the case of a device having a large body, the capacity of the inner space is also large correspondingly, so temperature rise of the inner space due to heat generation can be suppressed and there remains a certain margin for heat generation.

However, if a housing is made of aluminum diecast, production cost will be higher than a case of forming the housing of a resin. Further, when the device is formed compact, the capacity of the inner space will be smaller correspondingly. So, margin for heat generation will be lost and there is a risk of inviting sharp temperature rise of the inner space due to heat generation.

In view of the above, there is a need for an inexpensive charger which is compact and which yet provides favorable heat dissipation performance.

According to a characterizing feature of a charger relating to one preferred embodiment, the charger comprises:
a charging circuit board comprised of an input/output interface component and a charging circuit component mounted on a substrate having a first face and a second face which are in parallel and front/back relationship with each other; and
a housing including a first housing body to which the charging circuit board is fixed and a second housing body engageable with the first housing body to form together an inner space in which the charging circuit board is to be accommodated;
the second face of the substrate mounting thereon a heat generating component included in the circuit component; and
a heat dissipation pattern being formed at a part of the first face overlapped with at least a part of the heat generating component mounted on the second face as seen in a direction perpendicular to the first face.

With the charger having the above-described inventive arrangement, a heat dissipation pattern is formed at least at a part of the first face of the charging circuit board which part is overlapped with a part of the heat generating component mounted on the second face of the charging circuit board as seen in a direction perpendicular to the first face. With this arrangement, heat generated from the heat generating component mounted on the second face of the charging circuit board can be dissipated from the heat dissipation pattern of the first face. As such heat dissipation pattern can be formed simultaneously at the time of forming a wiring pattern on the substrate, heat dissipation measure can be provided without entailing additional component cost or additional production step.

In this way, it has become possible to provide an inexpensive charger which is compact and which yet provides favorable heat dissipation performance.

In the charger having the above-described arrangement, preferably, at a part of the first face of the charging circuit board where the circuit component is not mounted, there is disposed a heat dissipation body placed in contact with the first face and the housing.

With the above-described arrangement, heat which is conducted from the heat generating component to the first face is conducted subsequently through the heat dissipation body to reach the housing and then dissipated eventually from the housing to the outside. Thus, in comparison with an arrangement without such heat dissipation body, efficient heat dissipation is made possible. Especially, if the heat dissipation body is disposed in contact with the heat dissipation pattern, the heat which is conducted from the heat generating component to the heat dissipation pattern is conducted subsequently through the heat dissipation body to reach the housing and then dissipated eventually from the housing to the outside. With this, still further efficient heat dissipation is made possible.

According to a characterizing feature of a charger relating to a further embodiment of the present invention, the charger comprises:
a charging circuit board comprised of an input/output interface component and a charging circuit component mounted on a substrate having a first face and a second face which are in parallel front/back relationship with each other;
a housing including a first housing body to which the charging circuit board is fixed and a second housing body engageable with the first housing body to form together an inner space in which the charging circuit board is to be accommodated; and
a first heat dissipation body formed of a material having high thermal conductivity;
the second face of the substrate mounting thereon a heat generating component included in the circuit component;
a heat dissipation hole being formed in either one of the first housing body and the second housing body; and
the first heat dissipation body being fitted within the heat dissipation hole.

In the charger having the above-described arrangement, a heat dissipation hole is formed in either one of the first housing body and the second housing body and the first heat dissipation body formed of a material having high thermal conductivity is fitted within this heat dissipating hole. With this arrangement, the heat conducted from the heat generating component mounted on the second face of the charging circuit board is conducted through the inner space to reach the first heat dissipation body and then conducted through this first heat dissipation body to be dissipated eventually therefrom to the outside.

In this way, it has become possible to provide an inexpensive charger which is compact and which yet provides favorable heat dissipation performance.

In the charger having the above-described arrangement, preferably, the first heat dissipation body is formed of metal.

Such first heat dissipation body formed of metal has high thermal conductivity, so heat generated from the heat generating component can be dissipated to the outside in an efficient manner.

In the charger having the above-described arrangement, preferably, the first face of the charging circuit board is in opposition to the first heat dissipation body and a heat dissipation pattern is formed in the first face.

With the above-described arrangement, heat generated from the heat generating component mounted on the second face can be dissipated through the heat dissipation pattern of the first face. Since the heat dissipation pattern and the first heat dissipation body are in opposition to each other, the heat dissipated from the heat dissipation pattern can be dissipated to the outside from the first heat dissipation body. As such heat dissipation pattern can be formed simultaneously at the time of forming a wiring pattern on the substrate, heat dissipation measure can be provided without entailing additional component cost or additional production step.

In the charger having the above-described arrangement, preferably:
the first face of the charging circuit board is in opposition to the first heat dissipation body; and
at a part of the first face where the circuit component is not mounted, there is disposed a second heat dissipation body placed in contact with the first face and the first heat dissipation body.

With the above-described arrangement, heat which is conducted from the heat generating component to the first face is conducted subsequently through the second heat dissipation body to reach the first heat dissipation body and then conducted through this first heat dissipation body to be dissipated eventually to the outside. Thus, in comparison with an arrangement without such second heat dissipation body, efficient heat dissipation is made possible. Especially, if the second heat dissipation body is disposed in contact with both the heat dissipation pattern and the first heat dissipation body, heat conducted from the heat generating component to the heat dissipation pattern is conducted through the second heat dissipation body to reach the first heat dissipation body and then conducted through this first heat dissipation body to be dissipated to the outside. Therefore, still further efficient heat dissipation is made possible.

In the charger having the above-described arrangement, preferably:
at a part of the second face where the heat generating component is mounted, there are provided a plurality of through holes for heat conduction extending from the second face to the first face; and
at least one of the plurality of through holes is electrically connected to the heat dissipation pattern.

With the above-described arrangement, the heat generated from the heat generating component mounted on the second face can be conducted in an efficient manner through the through holes to the first face and the heat conducted to the first face can be dissipated from the heat dissipation pattern of the same first face. Thus, efficient heat dissipation is made possible. As such through holes can be formed simultaneously at the time of forming a wiring pattern on the substrate, heat dissipation measure can be provided without entailing additional component cost or additional production step.

In the charger having the above-described arrangement, preferably:
a plurality of heat generating components are mounted; and
at least one of the plurality of heat generating components is mounted near the center of the second face.

With mounting of a heat generating component near the center of the second face, in comparison with mounting thereof at an end of the second face, heat dissipation can be effected in uniform distribution over the entire inner space, so local concentration of temperature rise of the inner space can be suppressed and temperature rise around the heat generating component too can be suppressed.

In the charger having the above-described arrangement, preferably, a distance between the first face and the housing in the direction perpendicular to the first face of the charging circuit board is shorter than a distance between the second face and the housing in the direction perpendicular to the second face.

With the above-described arrangement, heat dissipated to the inner space from the first face having the heat dissipation pattern of the charging circuit board reaches the housing in a short time. This reached heat will then be conducted through the housing and dissipated to the outside in a short time. Therefore, heat generated from the heat generating component can be dissipated in an efficient manner.

In the charger having the above-described arrangement, preferably:
on the second face of the charging circuit board, a noise component included in the circuit component is mounted; and
a shielding body is inserted between the second face and the housing opposed to the second face.

As a shielding body is inserted between the second face of the substrate and the housing, it becomes possible to suppress exposure of the noise component mounted on the second face of the substrate to adverse influence of noise from the outside of the charger. Further, radiation of noise from the noise component to the outside of the charger can be suppressed also. Also, in case the noise component is mounted only on the second face of the substrate, the shielding body needs to be disposed only on the second face rather than on both faces of the substrate, so noise suppressing measure can be realized inexpensively.

In the charger having the above-described arrangement, preferably:
in the charging circuit board, the second face is fixed to the first housing body in opposition to this first housing body; and
on the first face, only a low-profile component included in the circuit component is mounted.

With the above-described arrangement, when the charging circuit board is fixed to the first housing body, the first face which is exposed to the outside mounts only a low-profile component and the circuit component(s) mounted on the second face is (are) protected by the first housing body. Therefore, under this condition, even if a shock or the like is applied to the charging circuit board from the outside, the charging circuit board is hardly damaged since the low-profile component has higher shock resistance than the other components.

In the charger having the above-described arrangement, preferably:
the first housing body and the second housing body are engaged with each other via a snap-fit arrangement involving engagement between a pawl portion and a hole portion; and
in either one of the first housing body and the second housing body, the pawl portion and an ornamental portion of the input/output interface component are formed.

With the above-described arrangement, of the two housing bodies together constituting the housing, one housing body in which the pawl portion and an ornamental portion of the input/output interface component are not formed can be of a simple shape. With this, for this one housing body, complicated work becomes unnecessary and degree of freedom in material selection therefor can be increased. As a result, it becomes also possible, if desired, to choose, for one housing body, various kinds of material (heat dissipating resin, metal, etc.) which have high heat dissipation performance, but which are difficult to work, whereby further improvement of the heat dissipation performance of the charger is made possible.

### BRIEF DESCRIPTION OF THE DRAWINGS

Fig. 1 is a perspective view showing a charger relating to a first embodiment,
Fig. 2 is a perspective view showing the charger relating to the first embodiment,
Fig. 3 is an exploded perspective view showing the charger relating to the first embodiment,
Fig. 4 is an exploded perspective view showing the charger relating to the first embodiment,
Fig. 5 is a section view taken along V-V line in Fig. 1,
Fig. 6 is a bottom view of a charging circuit board,
Fig. 7 is a plan view of the charging circuit board,
Fig. 8 is a section view taken along VIII-VIII line in Fig. 7,
Fig. 9 is an exploded perspective view showing a charger relating to a second embodiment,
Fig. 10 is a vertical section showing the charger relating to the second embodiment,
Fig. 11 is a perspective view showing a charger relating to a third embodiment,
Fig. 12 is a perspective view showing the charger relating to the third embodiment,
Fig. 13 is an exploded perspective view showing the charger relating to the third embodiment,
Fig. 14 is an exploded perspective view showing the charger relating to the third embodiment,
Fig. 15 is a section view taken along XV-XV line in Fig. 11,
Fig. 16 is a bottom view of a charging circuit board,
Fig. 17 is a plan view of the charging circuit board,
Fig. 18 is an exploded perspective view showing a charger relating to a fourth embodiment, and
Fig. 19 is a vertical section showing the charger relating to the fourth embodiment.

### DESCRIPTION OF EMBODIMENTS

Next, embodiments of a charger relating to the present invention will be explained with reference to the accompanying drawings. It is understood, however, that the present invention is not limited to these embodiments, but various modifications thereof are possible in a range not deviating from essence thereof.

### [First Embodiment]

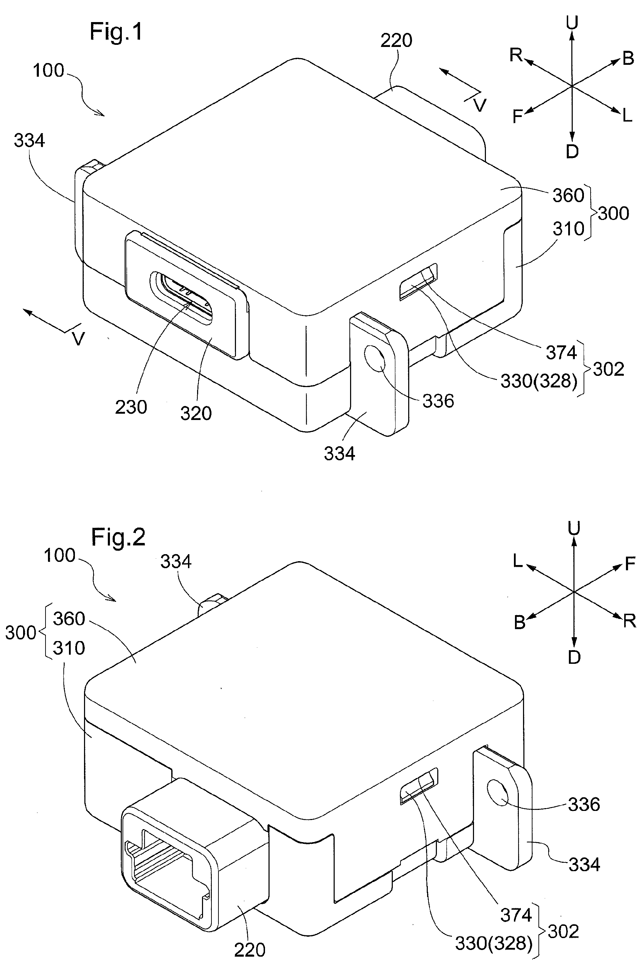

As shown in Figs. 1 through 5, a charger 100 relating to a first embodiment of the present invention includes a housing 300 consisting of a first housing body 310 and a second housing body 360, a charging circuit board 200 accommodated in an inner space 390 of the housing 300, and a shielding body 500 accommodated between the first housing 310 and the charging circuit board 200 inside the inner space 390. In the following explanation, in the charger 100 shown in Fig. 1, the side thereof where an output connector 230 (an example of an "input/output interface component") is disposed relative to the center portion of the charger 100 (the vicinity of the gravity center of the charger 100) will be defined as the "front side", the side where an input connector 220 (an example of an "input/output interface component") is disposed will be defined as the "rear (back) side", the side where the second housing body 360 is disposed will be defined as the "upper side", and the opposite to the side where the first housing body 310 is disposed will be defined as the "lower side", respectively. Also, the left and the right as seen in the direction from the center portion of the charger 100 toward the front side thereof will be defined as the "left side" and the "right side", respectively. And, the direction from the center portion of the charger 100 toward the front side and the direction toward the rear side will be defined as the front direction (denoted by "F" in the drawings) and the rear direction (denoted by "B" in the drawings), respectively. The direction toward the upper side will be defined as the upper direction (denoted by "U" in the drawings) and the direction toward the lower side will be defined as the lower direction (denoted by "D"), and the direction toward the left side will be defined as the "left direction" (denoted by "L) in the drawings and the direction toward the right side will be defined as the "right direction" (denoted by "R" in the drawings), respectively. Moreover, the direction along the front direction and the rear direction will be defined as the front/rear direction, the direction along the upper direction and the lower direction will be defined as the upper/lower direction, and the direction along the left direction and the right direction will be defined as the "left/right direction", respectively. Still further, the directions from the center portion of the charger 100 to the outside of the charger 100, such as the front direction, the rear direction, the upper direction, the lower direction, the left direction, the right direction will be referred to as the outer direction or outer side, and conversely, the directions from the outside of the charger 100 toward the center portion of the charger 100 will be referred to as the inner direction or inner side, respectively.

The first housing body 310 is formed of an insulator such as a resin and has a bottomed tubular shape with a lower wall 312 having a rectangular shape as seen in the upper/lower direction, and a front wall 314, a rear wall 316, left and right side walls 318, 318 which extend vertically upwards from the lower wall 312. The front wall 314 and the left and right side walls 318, 318 have their wall faces receded to the inner side in the course of their upward vertical extensions from the lower wall 312, thus having reduced thickness there. The reason for this thinning a portion of the wall is as follows. Namely, when the second housing body 360 is engaged with the first housing body 310, as shown in Figs. 1 and 2, the front wall 314, the side walls 318, 318 of the first housing body 310 may be formed flush with the front wall 364, and the side walls 368, 368 of the second housing body 360.

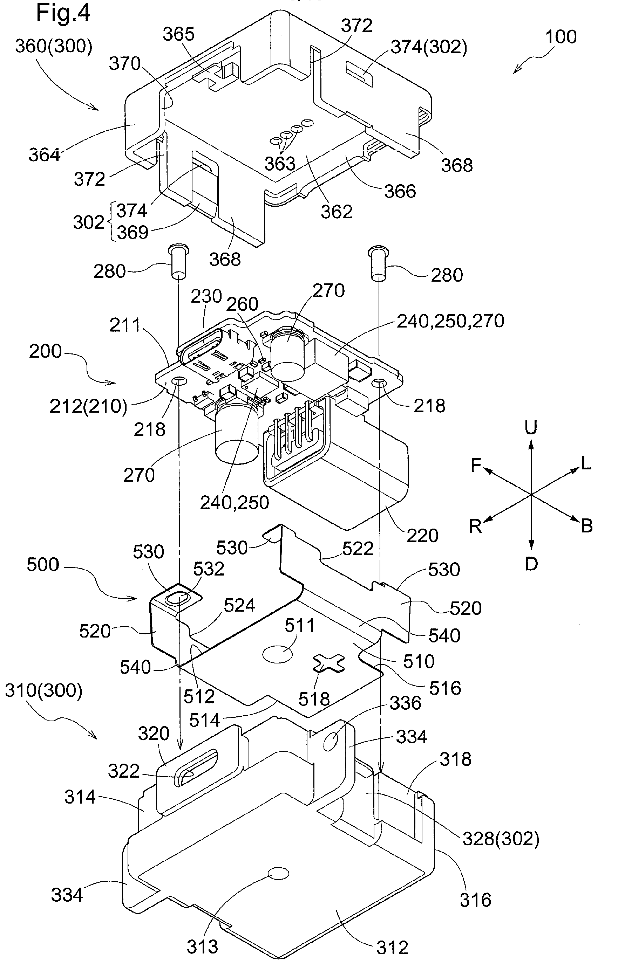

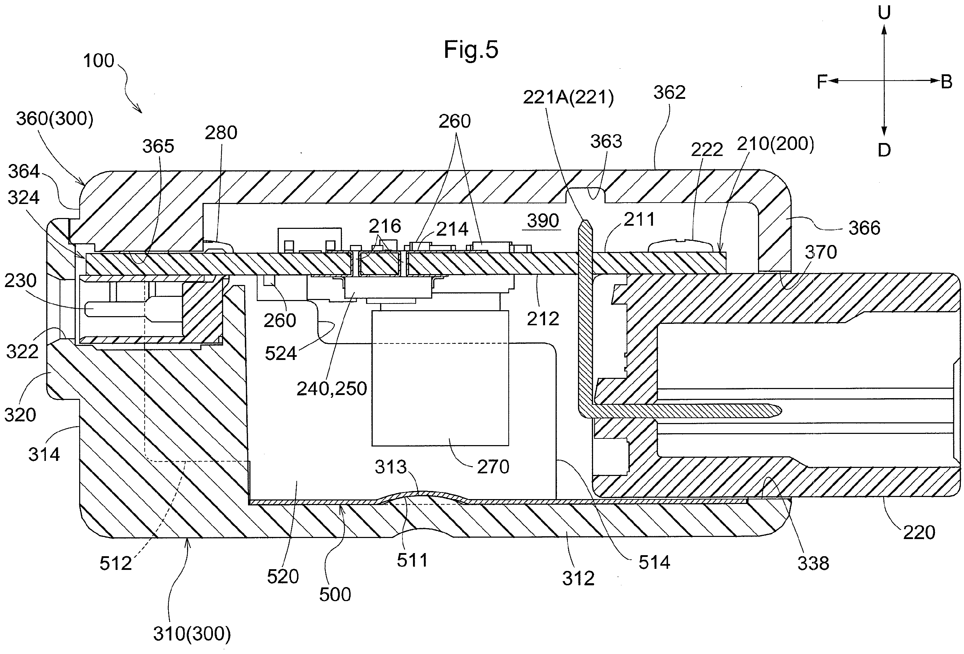

As shown in Fig. 4 and Fig. 5, at the center of the inner side face of the lower wall 312 of the first housing body 310, there is formed a circular protrusion 313 protruding to the inner direction. This circular protrusion 313 is to be fitted within a circular recess 511 of a shielding body 500 which will be described later.

As shown in Fig. 1 and Figs. 3 through 5, at the center in the left/right direction of the portion of the first housing body 310 where the front wall 314 is thinned, an ornamental portion 320 of the output connector 230 is formed. This ornamental portion 320 protrudes forwardly (outwardly) beyond the front wall 314 and has a rectangular shape elongate in the left/right direction and defines at the center thereof an oval-shaped through hole 322. This through hole 322 is provided for exposing an engaging portion of the output connector 230.

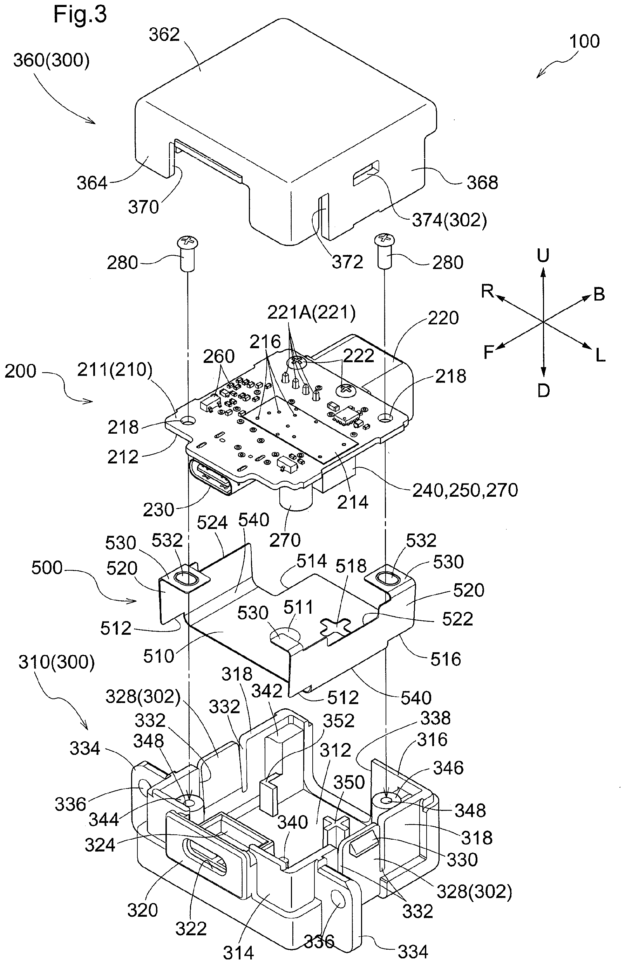

As shown in Fig. 3 and Fig. 5, rearwardly of the ornamental portion 320, there is formed a connector accommodating portion 324 having an angular tubular shape for accommodating the output connector 230 mounted on the charging circuit board 200. Downwardly of the inner space of the connector accommodating portion 324, there is formed a supporting rib (not shown) having an H-shaped cross section. The supporting rib is formed with such a height with which when the charging circuit board 200 is fixed to the first housing body 310, the output connector 230 may come into contact with the upper face thereof for fixation.

As shown in Fig. 3 and Fig. 4, at the center portions of the left and right side walls 318, 318 of the first housing body 310, there are formed cantilever portions 328 which constitute a snap-fit arrangement 302 between a retaining hole 374 (an example of a "hole portion") formed in the second housing body 360 and a tapered portion 369. The cantilever portion 328 is provided by forming a slit 332 at a part of the side wall 318,318 and on the side of its leading end (free end side), there is formed a pawl portion 330 extending to the outer side. When the pawl portion 330 is retained at the retaining hole 374, the second housing body 360 is engaged with the first housing body 310.

Forwardly of the cantilever portions 328 of the left and right side walls 318, 318 of the first housing body 310, there are formed flange portions 334, 334 protruding outwards from the side walls 318, 318. The lower side face of each flange portion 334 is placed in flush with the outer side face of the lower wall 312 and the length in the upper/lower direction of the flange portion 334 334 is slightly shorter than the length in the upper/lower direction of the side wall 318, 318. At upper side portions of the flange portions 334, 334, there are formed circular through holes 336, 336 formed to extend through the flange portions 334, 334 in the front/rear direction.

As shown in Fig. 3, in the rear wall 316 of the first housing body 310, there is formed a cutout portion 338 into which the input connector 220 having an outer shape with a rectangular-shaped cross section and mounted on the charging circuit board 200 is to be fitted. The cutout portion 338 is cutout from the upper end of the rear wall 316 to the vicinity in flush with the inner side face of the lower wall 312.

In the space delimited by the lower wall 312, the front wall 314, the rear wall 316 and the left and right side walls 318, 318 of the first housing body 310, there are formed a plurality of ribs on which the charging circuit board 200 is to be mounted. These ribs consist of a first rib 340 and a second rib 342 on which the charging circuit board 200 is to be mounted directly and a third rib 344 and a fourth rib 346 on which the charging circuit board 200 is to be mounted via the shielding body 500. Therefore, the height of the third rib 344 and the fourth rib 346 from the lower wall 312 is set lower than the height of the first rib 340 and the second rib 342 from the lower wall 312 by the plate thickness of the shielding body 500.

The first rib 340 protrudes inwards from the left side wall of the front wall 314 and is formed like a quadrangular prism. The second rib 342 protrudes inwards to come into contact with the right side wall 318 and the rear wall 316 and is formed like a quadrangular prism. The first rib 340 and the second rib 342 are formed near a diagonal line of the first housing body 310. The third rib 344 and the fourth rib 346 are formed near a diagonal line different from the diagonal line of the first housing 310 nearby where the first rib 340 and the second rib 342 are formed, as seen in the upper/lower direction. The third rib 344 is formed at the leading end protruding inwards from the right side wall of the front wall 314. The third rib 344 has a cylindrical shape and defines at the center thereof a lower hole 348 in which a screw 280 for fixing the charging circuit board 200 is to be threaded. The fourth rib 346 is formed at the leading end protruding inwards from the left side wall of the rear wall 316. The fourth rib 346 too has a cylindrical shape and defines at the center thereof a lower hole 348 in which a screw 280 for fixing the charging circuit board 200 is to be threaded.

From the lower wall 312 of the first housing body 310, there are also formed a cross-shaped rib 350 and an L-shaped rib 352. The L-shaped rib 352 extends from the second rib 342. The height of the cross-shaped rib 350 and the L-shaped rib 352 from the lower wall 312 is about a half of the height of the third rib 344 and the fourth rib 346 from the lower wall 312. Therefore, the cross-shaped rib 350 and the L-shaped rib 352 do not support the charging circuit board 200. The two adjacent walls constituting the cross-shaped rib 350 and the L-shaped rib 352 guide the corner portions of the rear face (face located on the inner side) of the input connector 220, so the cross-shaped rib 350 and the L-shaped rib 352 may be formed with such a height which can suppress deformation of the input connector 220 when an external force is applied to this input connector 220. Further, the cross-shaped rib 350 is formed in such a manner to be fitted in a cross-shaped hole 518 formed in the shielding body 500, so that movement of the shielding body 500 within the first housing body 310 is suppressed.

As shown in Fig. 3 and Fig. 4, the second housing body 360 is formed of an insulator such as a resin and has a bottomed tubular shape with an upper wall 362 having a rectangular shape as seen in the upper/lower direction, and a front wall 364, a rear wall 366, left and right side walls 368, 368 which extend vertically from the upper wall 362. The second housing body 360 has such an outer shape that when engaged with the first housing body 310, the respective outer faces of the front wall 364, the rear wall 366 and the side walls 368, 368 of the second housing body 360 may be formed flush with the respective outer faces of the front wall 314, the rear wall 316 and the side walls 318, 318 of the first housing body 310. The second housing body 360, when engaged with the first housing body 310, forms the housing 300. The housing 300 has the inner space 390 delimited by the front walls 314, 364, the rear walls 316, 366, the side walls 318, 318, 368, 368, the lower wall 312 and the upper wall 362 (see Fig. 5). In this inner space 390, the charging circuit board 200 is accommodated.

In the front wall 364 of the second housing body 360 and at the center portion thereof, there is formed a cutout portion 370 to be fitted to the outer circumference of the ornamental portion 320 of the first housing body 310. On the inner side of the cutout portion 370, there is formed an H-shaped rib 365 formed erect downwards from the upper wall 362 and unified also with the front wall 364. The H-shaped rib 365 comes into contact with the first face 211 of the charging circuit board 200 when the first housing body 310 and the second housing body 360 are engaged with each other. And, the H-shaped rib 365 clamps and holds the output connector 230 and the charging circuit board 200 in cooperation with a supporting rib of the connector accommodating portion 324 of the first housing body 310.

In the left and right side walls 368, 368 of the second housing body 360, there are formed, on more front side than the center portion, slits 372, 372 which will be fitted to the flange portions 334, 334 of the first housing body 310. In the inner side face at the center portion of each side wall 368, there is formed a tapered portion 369 which guides the pawl portion 330 of the cantilever portion 328 at the time of engagement with the first housing body 310. And, at a portion of the side wall 368 upwardly of the tapered portion 369, there is formed a retaining hole 374 in which the pawl portion 330 is to be fitted. The tapered portion 369 and the retaining hole 374 together with the cantilever portion 328 constitute the snap-fit arrangement 302.

The rear wall 366 of the second housing body 360 is formed to be mounted on the rear wall 316 of the first housing body 310 and this wall entirely is cut out to the vicinity of the upper wall 362. Of the rear wall 366, only a portion thereof opposed to the upper portion of the input connector 220 protrudes in a shape following the outer shape of the input connector 220. As shown in Figs. 3 through 5, a terminal 221 of the input connector 220 is disposed to extend through from the second face 212 to the first face 211 of the substrate 210. An end portion 221A of the terminal 221 protrudes in the direction perpendicular to the first face 211 of the substrate 210 and in opposition to the inner side face of the upper wall 362 of the second housing body 360. In an inner side face of the upper wall 362, at portions thereof opposed to the end portion 221A of the terminal 221, there are formed recesses 363 by a same number as the number of the terminals 221 (four in this embodiment) in order to avoid contact with the end portion 211A.

In the charger 100 of this embodiment, the pawl portion 330 and the ornamental portion 320 are formed in the first housing body 310. With this arrangement, of the two housing bodies 310, 360 together constituting the housing 300, the second housing body 360 in which the pawl portion 330 and the ornamental portion 320 are not formed can have a simple shape. With this, in the second housing body 360, no complicated work is needed and degree of freedom in selection of its material can be increased. As a result, for this second housing body 360, it is possible to select various kinds of material (heat dissipating resin or metal, or the like) which have high heat dissipation performance but which are difficult to work, for example. Thus, improvement of the heat dissipation performance of the charger 100 can be realized.

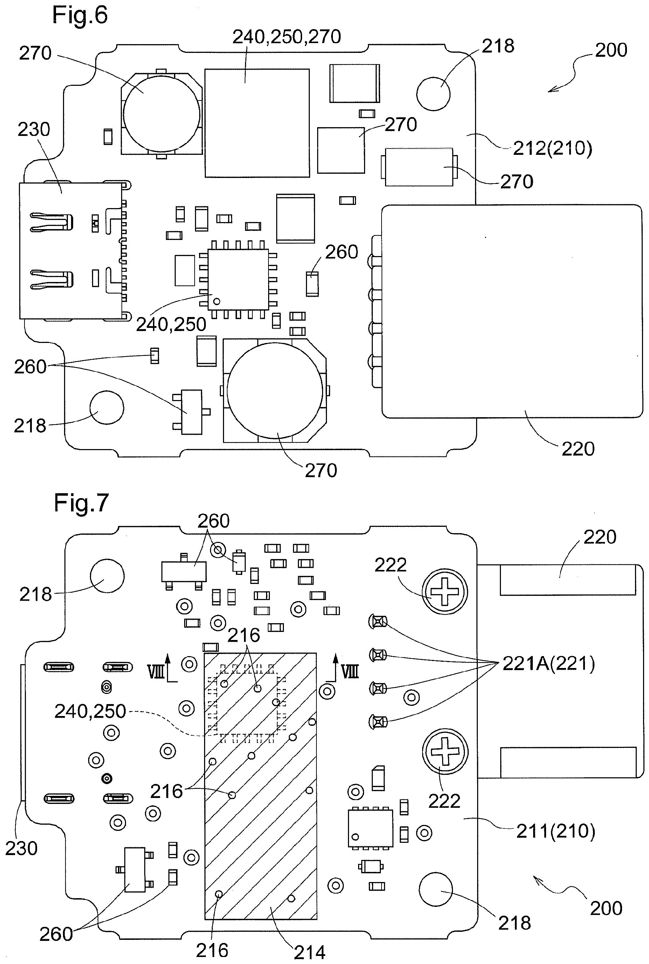

As shown in Figs. 3 through 7, the charging circuit board 200 is constituted with various charging circuit components such as the input connector 220, the output connector 230, a DC power source, a control IC, etc. being incorporated within the substrate 210. The substrate 210 has an approximately rectangular shape and protrudes forwards only at the portion thereof where the output connector 230 is to be mounted. On the charging circuit board 200, there are mounted a plurality of heat generating components 240 which are devices tending to generate heat, e.g. semiconductor devices such as an FET, a transistor (an example of the "circuit component"), a diode (an example of the "circuit component"), a main IC (an example of the "circuit component") for controlling the charger 100. The heat generating components 240 are vulnerable to heat, so it is desired that some heat dissipation measure should be provided therefor. The charging circuit board 200 mounts also certain noise components or devices 250 which can be devices that generate noise such as an IC or an inductor (an example of the "circuit component") and devices vulnerable to external noise such as an IC (an example of the "circuit component") which may malfunction due to influence from noise entering the pattern on the substrate 210. The charging circuit board 200 further mounts low-profile components 260 such as a chip resistor (an example of the "circuit component"), a chip capacitor (an example of the "circuit component"), a chip IC (an example of the "circuit component") and other high-profile components (an example of the "circuit component") 270. Some of the noise components 250 (e.g. the IC or the inductor) are heat generating components 240 also. For such noise components 250, it is desired that some noise suppression arrangement should be provided. The low-profile components 260 refer to components having a mounting height equal to or less than 1.15 mm.

Of these devices or components, on the first face 211 of the substrate 210, only the low-profile component 260 is mounted, whereas on the second face 212, the input connector 220, the output connector 230, the heat generating components 240, the noise component 250, the low-profile component 260 and the high-profile component 270 are mounted, and at least the noise component 250 is mounted on the second face 212 only. Of the plurality of heat generating components 240, at least one thereof is mounted near the center of the second face 212. Mounting of the heat generating component 240 near the center of the second face 212, in comparison with mounting thereof at an end portion, heat can be dissipated in uniform distribution over the entire inner space 390. So, in addition to the ability to suppress localization of temperature rise depending on the location of the inner space 390, suppression of temperature rise around the heat generating components 240 is also made possible.

The charging circuit board 200 is fixed to the first housing body 310, with the second face 212 being oriented downwards (the state of the second face 212 and the lower wall 312 being in opposition to each other). Near the diagonal line of the charging circuit board 200 (the right front corner and the left rear corner in this embodiment), through holes 218, 218 are formed. And, the charging circuit board 200 is disposed in the first housing body 310 in such a manner that the through holes 218, 218 are overlapped with the lower holes 348 formed respectively in the third rib 344 and the fourth rib 346 of the first housing body 310. And, fastening fixation is provided by the screws 280 threaded in the lower holes 348, 348 via the through holes 218, 218 (see Fig. 3).

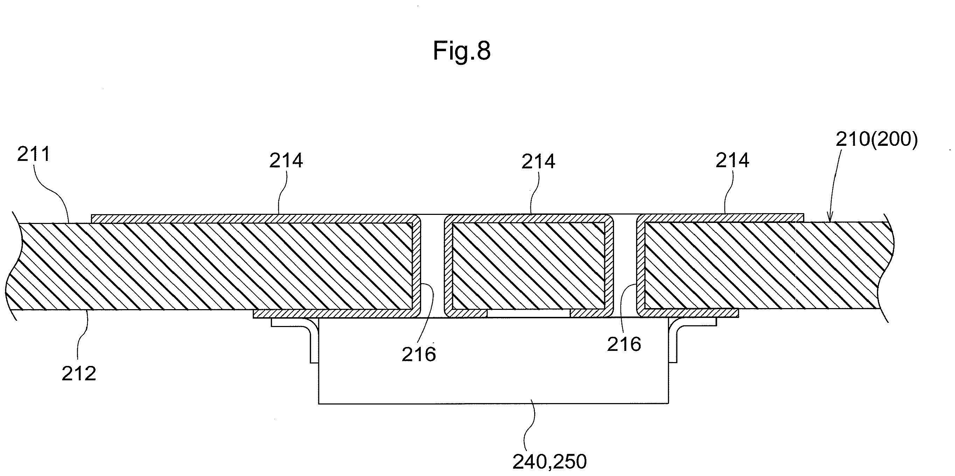

In the charging circuit board 200, in the region of the first face 211 overlapped at least with a part of the region of the second face 212 where the heat generating components 240 are mounted as seen in the upper/lower direction, none of such components as the low-profile component 260, the terminals of the input connector 220 are mounted, but a heat dissipation pattern 214 comprised of a plated copper foil is formed. More particularly, of the first face 211, at a part thereof overlapped with at least one or some of the heat generating components 240 mounted on the second face 212 in the direction perpendicular to the first face 211, the heat dissipation pattern 214 is formed. By forming this heat dissipation pattern 214 large, heat generated from the heat generating components 240 can be dissipated in an efficient manner from the heat dissipation pattern 214 to the inner space 390, whereby temperature rise of the heat generating components 240 can be suppressed. Moreover, in this embodiment, at portions of the second face 212 of the substrate 210 where at least one heat generating component 240 is mounted, there are provided a plurality of through holes 216 for heat conduction from the second face 212 to the first face 211. Specifically, as shown in Fig. 8, there are formed a plurality of through holes 216 in contact with the bottom faces (mounting faces) of the heat generating components 240 mounted on the second face 212 and at least one of the plurality of through holes 216 is electrically connected to the heat dissipation pattern 214 of the first face 211. Since plating is formed also in the inner circumferential face of the respective through hole 216, heat generated from the heat generating components 240 mounted on the second face 212 can be conducted in an efficient manner via the through holes 216 to the first face 211 and then dissipated from this first face 211 to the inner space 390. Especially, with the through hole 216 electrically connected with the heat dissipation pattern 214, heat generated from the heat generating component 240 can be dissipated from the bottom face of this heat generating component 240 through the through hole 216 to be conducted to the heat dissipation pattern 214 for dissipation therefrom. Therefore, further efficient heat dissipation is made possible. As the heat dissipation pattern 214 as well as the through hole 216 can be formed simultaneously at the time of forming the wiring pattern on the substrate 210, heat dissipation measure can be provided without entailing additional component cost or additional production step. In this, by electrically connecting the heat dissipation pattern 214 to a ground potential forming pattern of the charging circuit board 200, noise suppression arrangement for the noise component 250 can be provided also.

In the charger 100, as shown in Fig. 5, the distance from the first face 211 of the charging circuit board 200 to the upper wall 362 of the second housing body 360 (the distance between the first face 211 and the housing 300 in the direction perpendicular to the first face 211) is shorter than the distance from the second face 212 of the charging circuit board 200 to the lower wall 312 of the first housing body 310 (the distance between the second face 212 and the housing 300 in the direction perpendicular to the second face 212). With this arrangement, heat dissipated to the inner space 390 from the first face 211 having the heat dissipation pattern 214 of the charging circuit board 200 reaches the upper wall 362 in a short time. The reached heat will then be dissipated from the upper wall 362 to the outside. Therefore, heat generated from the heat generating component 240 can be discharged to the outside in an efficient manner. Especially, since only the low-profile component 260 is mounted on the first face 211 of the charging circuit board 200, the distance from the first face 211 to the upper wall 362 of the second housing body 360 can be further reduced, whereby dissipation of heat generated from the heat generating component 240 can be dissipated to the outside in an even more efficient manner.

As shown in Fig. 3 and Fig. 4, the shielding body 500 is formed by bending e.g. a metallic plate material of iron or the like which shields electromagnetic waves and is constituted of a lower portion 510 following along the inner side of the lower wall 312 of the first housing body 310, left and right side portions 520, 520 following respectively along the inner side faces of the left and right side walls 318, 318, a substrate supporting portion 530 supporting the charging circuit board 200 and bent portions 540, 540 bridging between the lower portion 510 and the side portions 520, 520. The shielding body 500 is inserted between the second face 212 of the substrate 210 and the first housing body 310, thus being accommodated inside the first housing body 310. The shielding body 500 is electrically connected to a ground potential forming pattern of the charging circuit board 200 and is inserted for noise suppression for the noise component 250 mounted on the second face 212.

In the lower portion 510 of the shielding body 500, there are formed a front cutout 512 for circumventing the connector accommodating portion 324, the first rib 340 and the third rib 344 which are formed near the front wall 314 of the first housing body 310, a right rear cutout 514 for circumventing the second rib 342 and the L-shaped rib 352 which are formed near the rear wall 316 and the right side wall 318, and a left rear cutout 516 for circumventing the fourth rib 346 protruding from the left side wall of the rear wall 316. Further, in this lower portion 510, there is formed a cross-shaped hole 518 to be fitted with the cross-shaped rib 350 protruding from the lower wall 312 of the first housing body 310. Still further, at the center of the lower portion 510, there is formed a circular recess 511 receded inwards from the outer side, into which the circular protrusion 313 protruding from the inner side face of the lower wall 312 of the first housing body 310 is to be fitted. With these, position fixing of the lower portion 510 relative to the first housing body 310 is realized.

In the left side portion 520, there is formed a left cutout 522 having a front/rear length slightly longer than a combined front/rear length of the cantilever portion 328 and the slits 332, 332 formed on the opposed sides thereof of the snap-fit arrangement 302 combined together. This left cutout 522 is cutout to a portion slightly lower than the lower end of the pawl portion 330 of the cantilever portion 328. The opposed ends of the left side portion 520 in the front/rear direction are bent inwards by 90 degrees to form substrate supporting portions 530, 530. Of these, in the substrate supporting portion 530 located on the rear side (left rear side), a through hole 532 having an oval shape is formed. Where, no such through hole is formed in the substrate supporting portion 530 located on the front side (left front side).

As shown in Fig. 3, the left rear substrate supporting portion 530 is sandwiched between the charging circuit board 200 and the fourth rib 346 and as the screw 280 extends through the through hole 218 and the through hole 532 to be threaded in the lower hole 348 of the fourth rib 346, the left rear substrate supporting portion 530 is fastened and fixed to the first housing body 310 together with the charging circuit board 200. The left front substrate supporting portion 530 mounts the charging circuit board 200, but being not fixed thereto.

In the right side portion 520, there is formed a right cutout 524 which is cut out from a slightly front side to a rear side of the slit 332 formed at the front side portion of the cantilever portion 328 of the snap-fit arrangement 302 and also to a side slightly lower than the lower end of the pawl portion 330 and which is cutout also from a portion slightly rear side of the slit 332 formed at the rear portion of the cantilever portion 328 to be continuous with the right rear cutout 514. The front end portion of the right side portion 520 in the front direction (right front direction) is bent inwards by 90 degrees to form a substrate supporting portion 530. In this right front substrate supporting portion 530, there is formed a through hole 532 having an oval shape. This substrate supporting portion 530 is sandwiched between the charging circuit board 200 and the third rib 344, and as the screw 280 extends through the through hole 218 and the through hole 532 to be threaded in the lower hole 348 of the third rib 344, the substrate supporting portion 530 is fastened and fixed to the first housing body 310 together with the charging circuit board 200.

As described above, as the shielding body 500 is inserted between the second face 212 of the substrate 210 and the first housing body 310, thus being accommodated inside this first housing body 310, it is possible to suppress exposure of the noise component 250 mounted on the second face 212 of the substrate 210 to adverse influence of noise from the outside of the charger 100 and also to suppress radiation of noise from the noise component 250 to the outside of the charger 100. In this embodiment, since the noise component 250 is mounted only on the second face 212 of the substrate 210, the shielding body 500 needs to be disposed not on the both faces of the substrate 210, but only on the side of the second face 212. Thus, noise suppression measure can be realized inexpensively. Moreover, since the shielding body 500 is formed by bending a metal plate, such noise suppression measure can be realized even more inexpensively.

Next, a method of manufacturing the charger 100 relating to the present embodiment will be explained.

On the first face 211 of the substrate 210 in which the wiring pattern, the heat dissipation pattern 214, the through holes 216, etc. are formed in advance, the low-profile components 260 are mounted by soldering and on the second face 212, the heat generating component 240, the noise component 250, the low-profile component 260, and the high-profile component 270 are mounted by soldering, whereby the charging circuit board 200 is manufactured. As for the input connector 220, fixation thereof to the substrate 210 is reinforced by inserting the screws 222 from the side of the first face 211.

Next, the shielding body 500 is inserted to the first housing body 310 and on this, the charging circuit board 200 is mounted with the second face 221 being oriented downwards. And, the screws 280, 280 are inserted to the through holes 218, 218 of the charging circuit board 200 and the through holes 532, 532 of the shielding body 500 and threaded in the lower holes 348, 348 formed respectively in the third rib 344 and the fourth rib 346 of the first housing body 310, and the charging circuit board 200 and the shielding body 500 are fastened and fixed to the first housing body 310 (see Fig. 3). Under this state, on the first face 211 exposed to the outside, only the low-profile component 260 is mounted and the input connector 220, the output connector 230, the heat generating component 240, the noise component 250, the low-profile component 260 and the high-profile component 270 mounted on the second face 212 are protected by the first housing body 310. Therefore, even if a shock or the like is applied from the outside to the charging circuit board 200, the charging circuit board 200 will hardly be damaged since the low-profile component 260 has higher shock resistance than the other components.

Next, the second housing body 360 is engaged with the first housing body 310 in which the charging circuit board 200, etc. have been accommodated. In this, as the pawl portions 330, 330 of the cantilever portions 328, 328 formed in the left and right side walls 318, 318 of the first housing body 310 are fitted in the retaining holes 374, 374 formed in the left and right side walls 368, 368 of the second housing body 360, the second housing body 360 is fixed to the first housing body 310. With engagement of the second housing body 360 to the first housing body 310, the inner space 390 is formed.

### [Second Embodiment]

Next, a charger 100 relating to a second embodiment of the invention will be explained. In the explanation of this embodiment, for the same arrangements as those of the first embodiment, same or like reference signs will be used and explanation thereof will be omitted.

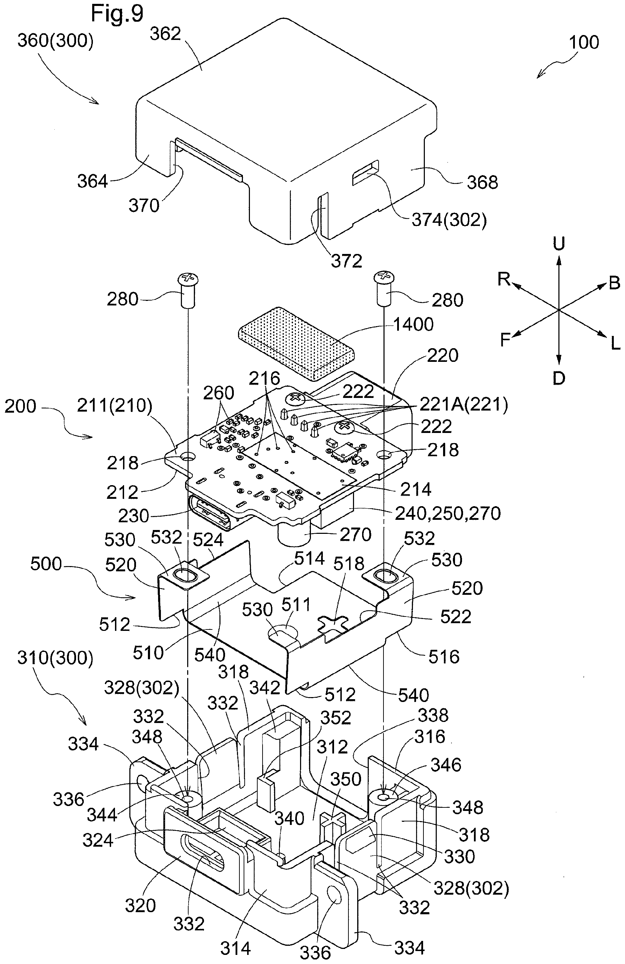

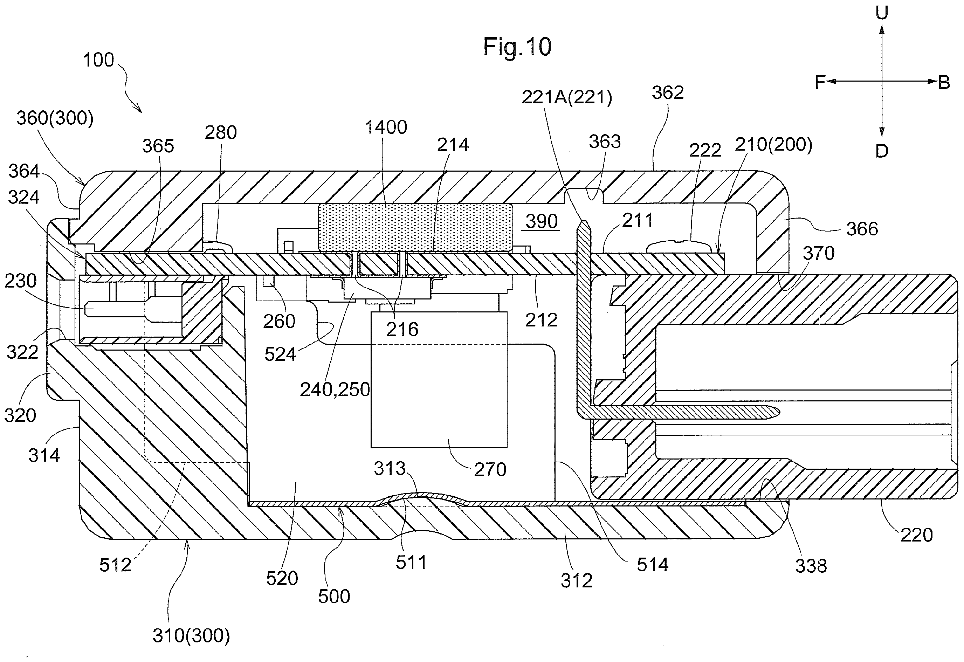

In this embodiment, as shown in Fig. 9 and Fig. 10, between the first face 211 of the charging circuit board 200 and the upper wall 362 of the second housing body 360, a heat dissipation body 1400 is disposed. The heat dissipation body 1400 is formed of a material having flexibility such as silicone and having also higher thermal conductivity than air. Preferably, the heat dissipation body 1400 is disposed in contact with the portion of the first face 211 of the charging circuit board 200 where the low-profile component 260 is not mounted and the upper wall 362 of the second housing body 360, respectively. In particular, if the heat dissipation body 1400 is disposed to come into contact with both the heat dissipation pattern 214 and the upper wall 362 of the second housing body 360, heat conducted from the heat generating component 240 via the through hole 216 to the heat dissipation pattern 214 will be conducted through the heat dissipation body 1400 to reach the second housing body 360 and then dissipated from this second housing body 360 to the outside. Therefore, in comparison with an arrangement having no such heat dissipation body 1400, efficient heat dissipation is made possible.

### [Third Embodiment]

Next, a charger 100 relating to a third embodiment of the invention will be explained. In the explanation of this embodiment, for the same arrangements as those of the first embodiment, same or like reference signs will be used and explanation thereof will be omitted.

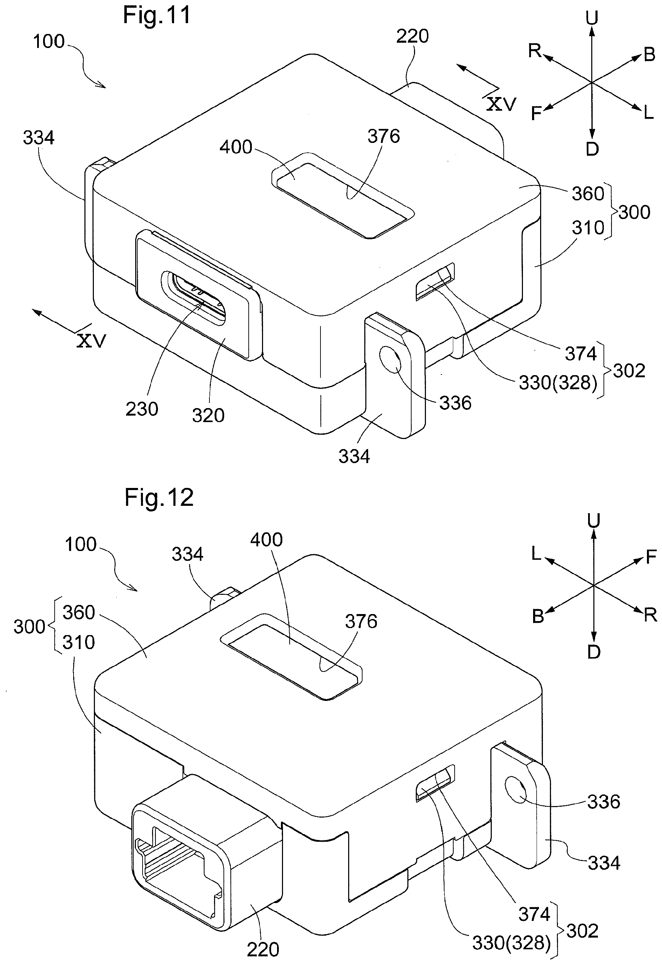

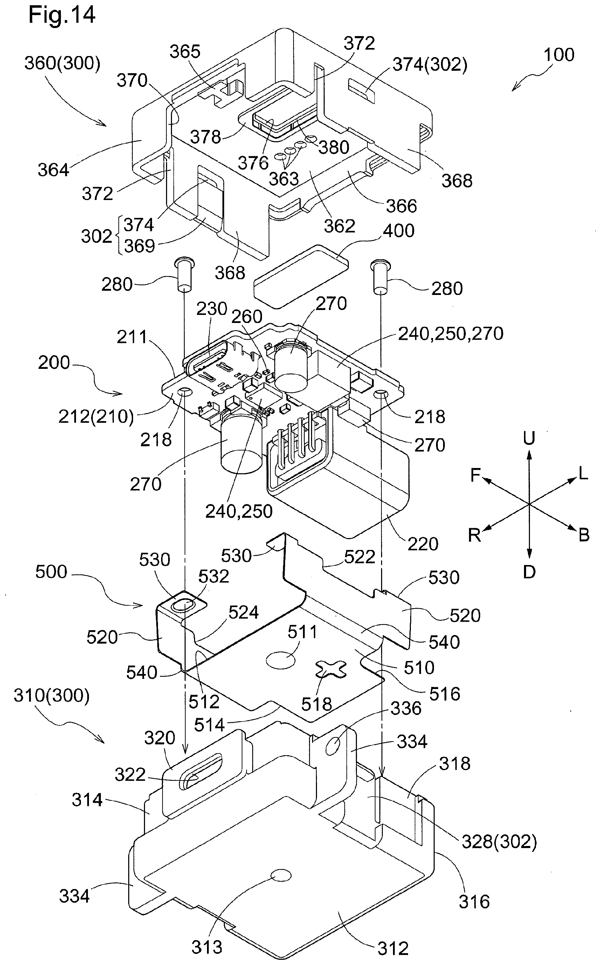

As shown in Figs. 11 through 15, a charger 100 relating to the third embodiment includes a housing 300 consisting of a first housing body 310 and a second housing body 360, a charging circuit board 200 accommodated in an inner space 390 inside the housing 300, a shielding body 500 accommodated between the first housing body 310 inside the inner space 390 and the charging circuit board 200, and a first heat dissipation body 400 formed of a material having a high thermal conductivity such as a metal and attached to the second housing body 360. In the following explanation, in the charger 100 shown in Fig. 11, the side thereof where an output connector 230 (an example of an "input/output interface component") is disposed relative to the center portion of the charger 100 (the vicinity of the gravity center of the charger 100) will be defined as the "front side", the side where an input connector 220 (an example of an "input/output interface component") is disposed will be defined as the "rear (back) side", the side where the first heat dissipation body 400 is disposed will be defined as the "upper side", and the side opposite to the side where the first heat dissipation body 400 is disposed will be defined as the "lower side", respectively. Also, the left and the right as seen in the direction from the center portion of the charger 100 toward the front side thereof will be defined as the "left side" and the "right side", respectively. And, the direction from the center portion of the charger 100 toward the front side and the direction toward the rear side will be defined as the front direction (denoted by "F" in the drawings) and the rear direction (denoted by "B" in the drawings), respectively. The direction toward the upper side will be defined as the upper direction (denoted by "U" in the drawings) and the direction toward the lower side will be defined as the lower direction (denoted by "D"), and the direction toward the left side will be defined as the "left direction" (denoted by "L) in the drawings and the direction toward the right side will be defined as the "right direction" (denoted by "R" in the drawings), respectively. Moreover, the direction along the front direction and the rear direction will be defined as the front/rear direction, the direction along the upper direction and the lower direction will be defined as the upper/lower direction, and the direction along the left direction and the right direction will be defined as the "left/right direction", respectively. Still further, the directions from the center portion of the charger 100 to the outside of the charger 100, such as the front direction, the rear direction, the upper direction, the lower direction, the left direction, the right direction will be referred to as the outer direction or outer side, and conversely, the directions from the outside of the charger 100 toward the center portion of the charger 100 will be referred to as the inner direction or inner side, respectively.

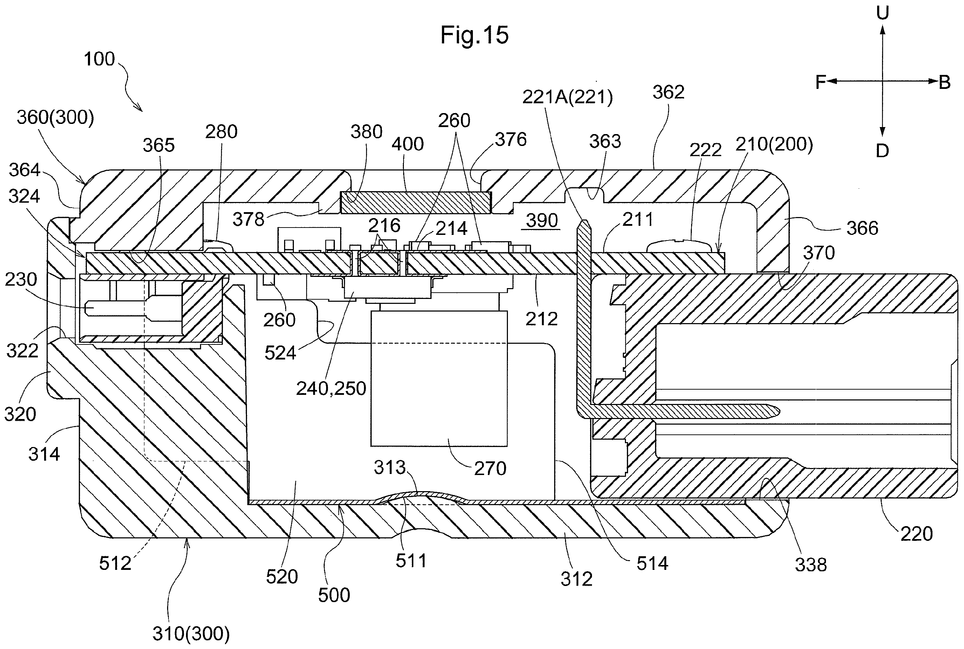

In the upper wall 362 of the second housing body 360, there is formed a heat dissipation hole 376 as a through hole in which the first heat dissipation body 400 to be described later is to be fitted. The heat dissipation hole 376 has a pentagonal shape formed by C-chamfering only one corner (the right front corner in this embodiment) of a rectangular shape as seen in the vertical direction. In the inner side face of the upper wall 362, the circumference of the heat dissipation hole 376 has an annular protrusion 378 slightly protruding inwards. Further, the heat dissipation hole 376 includes, in its inner circumferential face, a stepped portion which serves as a stopper 380 (see Fig. 15) for preventing inadvertent detachment of the first heat dissipation body 400 to the outside of the second housing body 360. The stopper 380 is formed on more outer side (upper side) than the inner side face of the upper wall 362.

The first heat dissipation body 400 is formed as a plate having the same pentagonal shape as the shape of the heat dissipation hole 376 and is fitted in the heat dissipation hole 376 formed in the upper wall 362 of the second housing body 360. The first heat dissipation body 400 employs a material having high thermal conductivity, such as aluminum, silver, copper, iron, etc. and can dissipate heat generated in the charging circuit board 200 to the outside in an efficient manner. The plate thickness of the first heat dissipation body 400 is slightly smaller than the plate thickness of the upper wall 362. The first heat dissipation body 400 is inserted to the heat dissipation hole 376 until it comes into contact with the stopper 380 from the inner side face of the upper wall 362. The first heat dissipation body 400 is fixedly attached to the heat dissipation hole 376 by such method as adhesive bonding. The lower face of the first heat dissipation body 400 (the face opposite to the face placed in contact with the stopper 380), when fixedly attached to the heat dissipation hole 376, is disposed flush with the leading end face of the annular protrusion 378. If the first heat dissipation body 400 is formed of a metal plate as above, this can be manufactured by a metal press punching work, so the first heat dissipation body 400 can be manufactured inexpensively. Further, heat reaching the first heat dissipation body 400 in the inner space 390 can be conducted speedily through the first heat dissipation body 400 having high thermal conductivity and dissipated to the outside.

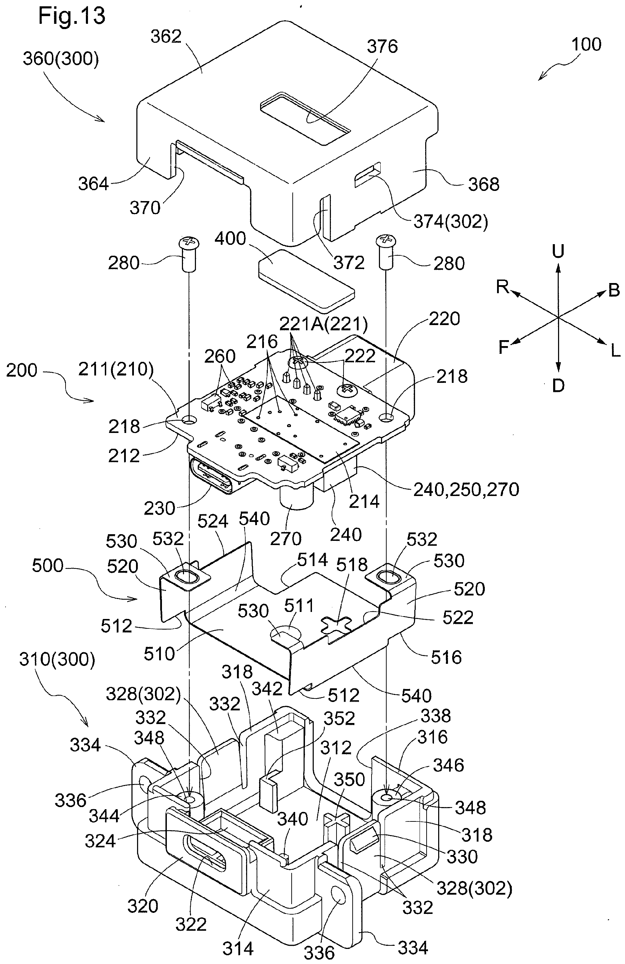

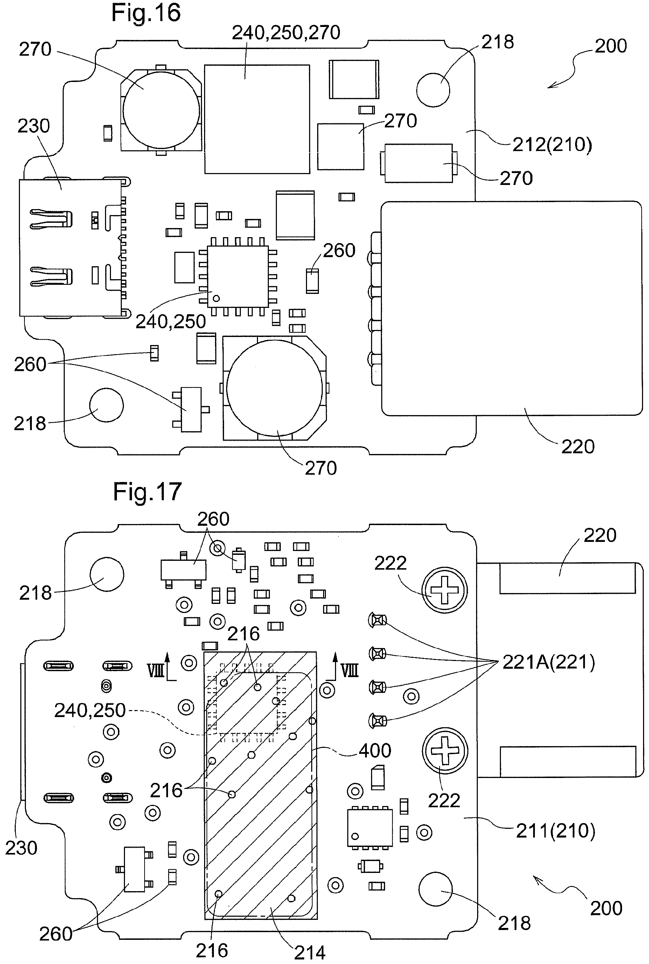

As shown in Figs. 13 through 17, the charging circuit board 200 is manufactured with causing a substrate 210 to incorporate various charging circuit components such as an input connector 220, an output connector 230, a DC current power source, a control IC, etc. The substrate 210 has an approximately rectangular shape and protrudes to the front side only at the portion thereof where the output connector 230 is mounted. The charging circuit board 200 mounts thereon a plurality of heat generating components 240, noise components 250, low-profile components 260 and other high-profile components (as example of "circuit component") 270.

In the charger 100, as shown in Fig. 15, the distance from the first face 211 of the charging circuit board 200 to the upper wall 362 of the second housing body 360 (the distance between the first face 211 and the housing 300 in the direction perpendicular to the first face 211) is shorter than the distance from the second face 212 of the charging circuit board 200 to the lower wall 312 of the first housing body 310 (the distance between the second face 212 and the housing 300 in the direction perpendicular to the second face 212). With this arrangement, heat dissipated to the inner space 390 from the first face 211 having the heat dissipation pattern 214 of the charging circuit board 200 can quickly reach the first heat dissipation body 400 fitted in the heat dissipation hole 376 of the upper wall 362. And, this reached heat will be conducted through the first heat dissipation body 400 having high thermal conductivity to be dissipated to the outside in a short time. So, heat generated from the heat generating components 240 can be dissipated to the outside in an efficient manner. In particular, since the first face 211 of the charging circuit board 200 mounts only the low-profile components 260, the distance from the first face 211 to the upper wall 362 (the first heat dissipation body 400) of the second housing body 360 can be further reduced, so the heat generated from the heat generating components 240 can be dissipated to the outside in an even more efficient manner.

Next, a method of manufacturing the charger 100 relating to the present embodiment will be explained.

On the first face 211 of the substrate 210 in which the wiring pattern, the heat dissipation pattern 214, the through holes 216, etc. are formed in advance, the low-profile components 260 are mounted by soldering and on the second face 212, the heat generating component 240, the noise component 250, the low-profile component 260, and the high-profile component 270 are mounted by soldering, whereby the charging circuit board 200 is manufactured. As for the input connector 220, fixation thereof to the substrate 210 is reinforced by inserting the screws 222 from the side of the first face 211.

Next, the shielding body 500 is inserted to the first housing body 310 and on this, the charging circuit board 200 is mounted with the second face 221 being oriented downwards. And, the screws 280, 280 are inserted to the through holes 218, 218 of the charging circuit board 200 and the through holes 532, 532 of the shielding body 500 and threaded in the lower holes 348, 348 formed respectively in the third rib 344 and the fourth rib 346 of the first housing body 310, and the charging circuit board 200 and the shielding body 500 are fastened and fixed to the first housing body 310 (see Fig. 13). Under this state, on the first face 211 exposed to the outside, only the low-profile components 260 are mounted and the input connector 220, the output connector 230, the heat generating component 240, the noise component 250, the low-profile component 260 and the high-profile component 270 mounted on the second face 212 are protected by the first housing body 310. Therefore, even if a shock or the like is applied from the outside to the charging circuit board 200, the charging circuit board 200 will hardly be damaged since the low-profile component 260 has higher shock resistance than the other components.

Next, the first heat dissipation body 400 is fixed in the heat dissipation hole 376 of the second housing body 360 by such method as adhesive bonding. And, the second housing body 360 is engaged to the first housing body 310 accommodating the charging circuit board 200, etc. In this, as the pawl portions 330, 330 of the cantilever portions 328, 328 formed in the left and right side walls 318, 318 of the first housing body 310 are fitted in the retaining holes 374, 374 formed in the left and right side walls 368, 368 of the second housing body 360, the second housing body 360 is fixed to the first housing body 310. With engagement of the second housing body 360 to the first housing body 310, the inner space 390 is formed.

### [Fourth Embodiment]

Next, a charger 100 relating to a fourth embodiment of the invention will be explained. In the explanation of this embodiment, for the same arrangements as those of the first and third embodiments, same or like reference signs will be used and explanation thereof will be omitted.

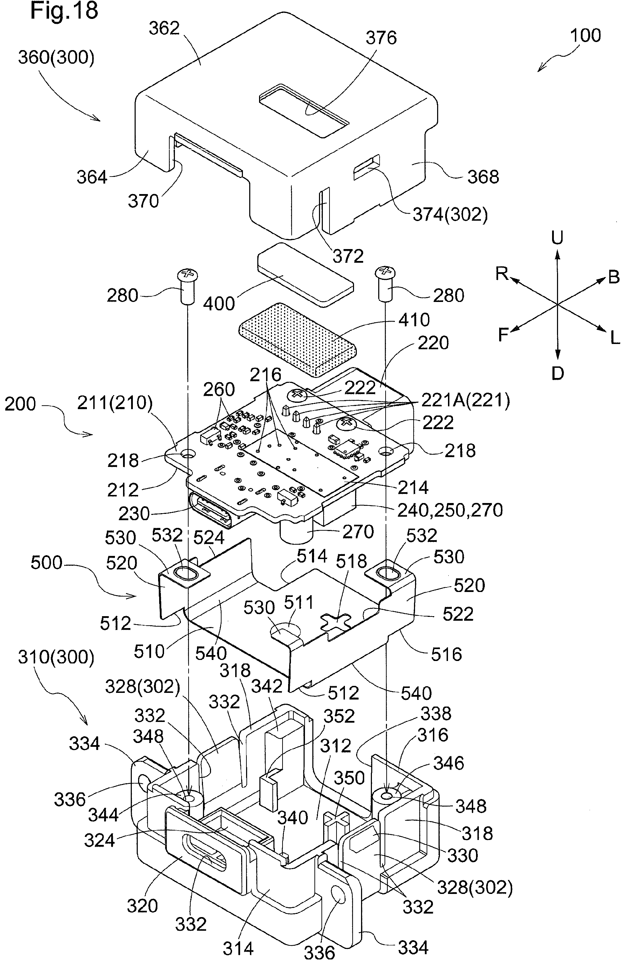

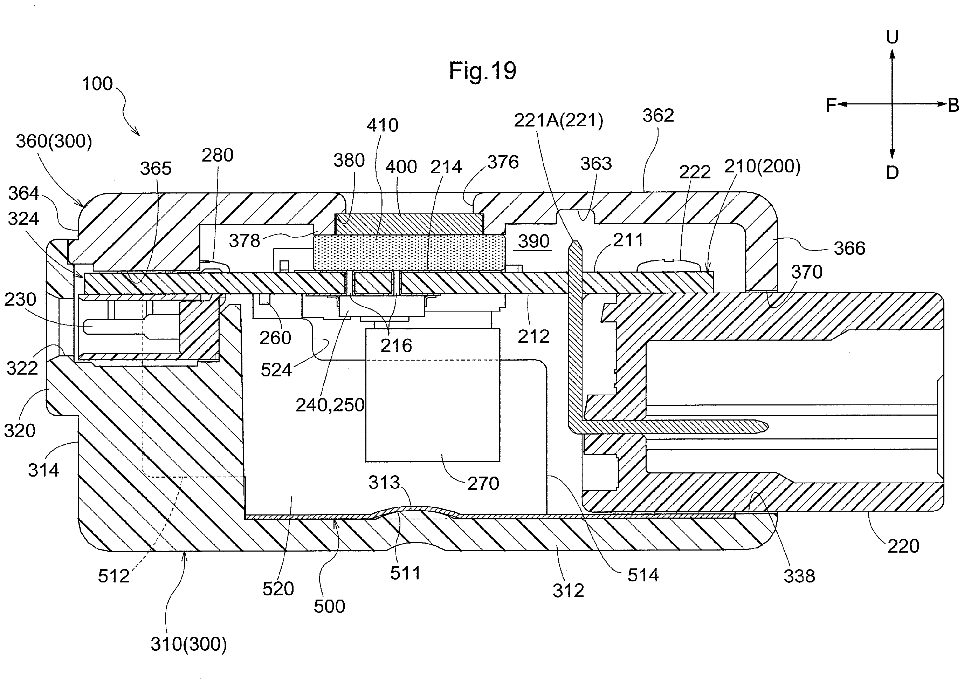

In this embodiment, as shown in Fig. 18 and Fig. 19, between the first face 211 of the charging circuit board 200 and the upper wall 362 of the second housing body 360, a second heat dissipation body 410 is disposed. The second heat dissipation body 410 is formed of a material having flexibility such as silicone and having also higher thermal conductivity than air. Preferably, the second heat dissipation body 410 is disposed in contact with the portion of the first face 211 of the charging circuit board 200 where the low-profile component 260 is not mounted and the upper wall 362 of the second housing body 360, respectively. In particular, if the second heat dissipation body 410 is disposed to come into contact with both the heat dissipation pattern 214 and the first heat dissipation body 400, heat conducted from the heat generating component 240 via the through hole 216 to the heat dissipation pattern 214 will be conducted through the second heat dissipation body 410 to reach the first heat dissipation body 400 and then conducted through the first heat dissipation body 400 to be dissipated to the outside. Therefore, in comparison with an arrangement having no such second heat dissipation body 410, efficient heat dissipation is made possible.

### [Other Embodiments]

(1) In the first and second embodiments, in the area of the first face 211 overlapped with at least a part of the second face 212 where the heat generating components 240 are mounted as seen in the vertical direction, the heat dissipation pattern 214 is formed. Instead, at least one of the plurality of heat generating components 240 may be mounted at a portion not overlapped at all with the area where the heat dissipation pattern 214 is formed as seen in the vertical direction. In such case too, it is preferred that the through hole 216 be formed to come into contact with the bottom face (mounting face) of the heat generating component 240 mounted on the second face 212. In this, however, the through hole 216 is not connected to the heat dissipation pattern 214 of the first face 211.

(2) In the foregoing respective embodiments, the charging circuit board 200 is fixed to the first housing body 310. However, it may be fixed to the second housing body 360 instead.

(3) In the third and fourth embodiments, the first heat dissipation body 400 is attached to the second housing body 360. Instead, it may be attached to the first housing body 310, not to the second housing body 360. Further alternatively, the first heat dissipation body 400 may be attached to both the first housing body 310 and the second housing body 360.

(4) In the third embodiment and the fourth embodiment, at the area of the first face 211 overlapped with at least a part of the area of the second face 212 where in the heat generating component 240 is mounted as seen in the vertical direction, the heat dissipation pattern 214 is formed. Alternatively, no heat dissipation pattern 214 at all may be formed in the first face 211. Further alternatively, even if the heat dissipation pattern 214 is formed in the first face 211, at least one of the plurality of heat generating components 240 may be mounted at a portion not overlapped at all with the area where in the heat dissipation pattern 214 is formed as seen in the vertical direction. In this case too, it is preferred that the through hole 216 be formed to come into contact with the bottom face (mounting face) of the heat generating component 240 mounted on the second face 212. However, in this case, the through hole 216 is not connected to the heat dissipation pattern 214 of the first face 211.

## Claims

1. A charger comprising:
a charging circuit board (200) comprised of an input/output interface component (220, 230) and a charging circuit component (240, 250, 260) mounted on a substrate (210) having a first face (211) and a second face (212) which are in parallel and front/back relationship with each other; and
a housing (300) including a first housing body (310) to which the charging circuit board (200) is fixed and a second housing body (360) engageable with the first housing body (310) to form together an inner space (390) in which the charging circuit board (200) is to be accommodated;
the second face (212) of the substrate (210) mounting thereon a heat generating component (240) included in the circuit component (240, 250, 260); and
a heat dissipation pattern (214) being formed at a part of the first face (211) overlapped with at least a part of the heat generating component (240) mounted on the second face (212) as seen in a direction perpendicular to the first face (211).

2. The charger of claim 1, wherein at a part of the first face (211) of the charging circuit board (200) where the circuit component (240, 250, 260) is not mounted, there is disposed a heat dissipation body (1400) placed in contact with the first face (211) and the housing (300).

3. A charger comprising:
a charging circuit board (200) comprised of an input/output interface component (220, 230) and a charging circuit component (240, 250, 260) mounted on a substrate (210) having a first face (211) and a second face (212) which are in parallel front/back relationship with each other;
a housing (300) including a first housing body (310) to which the charging circuit board (200) is fixed and a second housing body (360) engageable with the first housing body (310) to form together an inner space (390) in which the charging circuit board (200) is to be accommodated; and
a first heat dissipation body (400) formed of a material having high thermal conductivity;
the second face (212) of the substrate (210) mounting thereon a heat generating component (240) included in the circuit component (240, 250, 260);
a heat dissipation hole (376) being formed in either one of the first housing body (310) and the second housing body (360); and
the first heat dissipation body (400) being fitted within the heat dissipation hole (376).

4. The charger of claim 3, wherein the first heat dissipation body (400) is formed of metal.

5. The charger of claim 3 or 4, wherein the first face (211) of the charging circuit board (200) is in opposition to the first heat dissipation body (400) and a heat dissipation pattern (214) is formed in the first face (211).

6. The charger of any one of claims 3-5, wherein:
the first face (211) of the charging circuit board (200) is in opposition to the first heat dissipation body (400); and
at a part of the first face (211) where the circuit component (240, 250, 260) is not mounted, there is disposed a second heat dissipation body (410) placed in contact with the first face (211) and the first heat dissipation body (400).

7. The charger of any one of claims 1, 2 and 5, wherein:
at a part of the second face (212) where the heat generating component (240) is mounted, there are provided a plurality of through holes (216) for heat conduction extending from the second face (212) to the first face (211); and
at least one of the plurality of through holes (260) is electrically connected to the heat dissipation pattern (214).

8. The charger of any one of claims 1-7, wherein:
a plurality of heat generating components (240) are mounted; and
at least one of the plurality of heat generating components (240) is mounted near the center of the second face (212).

9. The charger of any one of claims 1-8, wherein a distance between the first face (211) and the housing (300) in the direction perpendicular to the first face (211) of the charging circuit board (200) is shorter than a distance between the second face (212) and the housing (300) in the direction perpendicular to the second face (212).

10. The charger of any one of claims 1-9, wherein:
on the second face (212) of the charging circuit board (200), a noise component (250) included in the circuit component (240 250, 260) is mounted; and
a shielding body (500) is inserted between the second face (212) and the housing (300) opposed to the second face (212).

11. The charger of any one of claims 1-10, wherein:
in the charging circuit board (200), the second face (212) is fixed to the first housing body (310) in opposition to this first housing body (310); and
on the first face (211), only a low-profile component (260) included in the circuit component (240, 250, 260) is mounted.

12. The charger of any one of claims 1-11, wherein:
the first housing body (310) and the second housing body (360) are engaged with each other via a snap-fit arrangement (302) involving engagement between a pawl portion (330) and a hole portion (374); and
in either one of the first housing body (310) and the second housing body (360), the pawl portion (330) and an ornamental portion (320) of the input/output interface component (220, 230) are formed.
